# EUROPÄISCHE PATENTANMELDUNG

(11) **EP 4 614 569 A1**
(43) Veröffentlichungstag der Anmeldung: **10.09.2025**
(21) Anmeldenummer: 25161732.0
(22) Anmeldetag: 05.03.2025
(51) Int. Cl.: H01L 25/07

(54) **HALBBRÜCKENSCHALTUNG**

(30) Priorität: 08.03.2024 DE 102024202199
(71) Anmelder: VOLKSWAGEN AG, 38440 Wolfsburg (DE)
(72) Erfinder: Wilke, Robert, 38440 Wolfsburg (DE); Arnaout, Samy, 38440 Wolfsburg (DE); Kraft, Silke, 38440 Wolfsburg (DE)

(57) **Zusammenfassung**

Die Erfindung betrifft eine Halbbrückenschaltung (1), umfassend mindestens zwei High-Side-Transistoren (T1, T2) und mindestens zwei Low-Side-Transistoren (T3, T4), die jeweils parallel geschaltet sind, wobei die Transistoren (T1-T4) auf einem gemeinsamen Substrat (3) mit einer Metallisierung angeordnet sind, wobei die mindestens zwei High-Side-Transistoren (T1, T2) und die mindestens zwei Low-Side-Transistoren (T3, T4) jeweils spiegelsymmetrisch zueinander angeordnet sind oder um 180° gedreht zueinander angeordnet sind, wobei Kontaktlaschen (4-7) für einen positiven Spannungsanschluss (DC+), einen negativen Spannungsanschluss (DC-) und einen Phasenanschluss jeweils spiegelsymmetrisch ausgebildet sind, wobei zwischen den High-Side-Transistoren (T1, T2) und zwischen den Low-Side-Transistoren (T3, T4) mindestens ein zusätzliches Substrat (8, 9) auf die Metallisierung des Substrats (3) aufgebracht ist, wobei ein gemeinsamer Gate-Anschluss für die High-Side-Transistoren (T1, T2) und ein gemeinsamer Gate-Anschluss für die Low-Side-Transistoren (T3, T4) auf dem mindestens einen zusätzlichen Substrat (8, 9) ist.

## Beschreibung

Die Erfindung betrifft eine Halbrückenschaltung mit mindestens zwei High-Side-Transistoren und mindestens zwei Low-Side-Transistoren, die jeweils parallel geschaltet sind.

Halbbrückenschaltungen kommen vielfach in verschiedenen Schaltungen wie Pulswechselrichter oder DC/DC-Wandlern zum Einsatz. Dabei können diese auch sehr hohe Spannungen und Ströme schalten. Die Leistungshalbleiter der Halbbrücke wie IGBTs oder MOSFETs sind dabei Bauelemente, die beispielsweise auf einem gemeinsamen Substrat angeordnet sind. Dabei sind insbesondere die MOSFETs in verschiedener Technologie bekannt, beispielsweise als Si- oder SiC-Transistoren. Insbesondere bei SiC-Transistoren sind die bisher erreichbaren Chipflächen noch begrenzt, sodass deren Stromtragfähigkeit begrenzt ist. Zur Lösung dieses Problems ist es bekannt, zwei oder mehr MOSFETs parallel zu schalten.

Aus der DE 10 2022 204 400 A1 ist ein Wechselrichter mit mindestens einer Halbbrücke bekannt, wobei die Halbbrücke mindestens einen High-Side-Transistor und einen Low-Side-Transistor aufweist. In einer bevorzugten Ausführungsform ist vorgesehen, dass die Halbbrücke jeweils vier High-Side-Transistoren und vier Low-Side-Transistoren aufweist, wobei die vier High-Side-Transistoren und die vier Low-Side-Transistoren jeweils parallel geschaltet sind. Dabei sind die High-Side-Transistoren und die Low-Side-Transistoren in zwei Reihen angeordnet, wobei die Metallisierung der Gleichspannungsanschlüsse und die Metallisierung des Wechselspannungsanschlusses derart strukturiert sind, dass sich ein zentraler Einspeisepunkt für alle High-Side-Transistoren und ein zentraler Einspeisepunkt für alle Low-Side-Transistoren ausbildet. Hierdurch soll der Strom möglichst gleichmäßig auf die Transistoren aufgeteilt werden.

Eine weitere Möglichkeit, den Strom gleichmäßig auf die Transistoren aufzuteilen, ist eine Einzel-Gate-Ansteuerung, die aber technisch sehr aufwendig ist, da komplexere Gate-Treiber verwendet werden müssen und die Anzahl der Steuer-Pins zunimmt.

Eine weitere Möglichkeit ist es, die Leistungshalbleiter zu sortieren und Leistungshalbleiter mit möglichst ähnlichem Schaltverhalten parallel zu schalten.

Der Erfindung liegt das technische Problem zugrunde, eine Halbbrückenschaltung mit mindestens zwei High-Side-Transistoren und mindestens zwei Low-Side-Transistoren zu schaffen, die jeweils parallel geschaltet sind und ohne Einzel-Gate-Ansteuerung eine gleichmäßige Stromverteilung aufweisen, wobei thermische Probleme reduziert werden.

Die Lösung des technischen Problems ergibt sich durch eine Halbbrückenschaltung mit den Merkmalen des Anspruchs 1. Weitere vorteilhafte Ausgestaltungen der Erfindung ergeben sich aus den Unteransprüchen.

Die Halbbrückenschaltung umfasst mindestens zwei High-Side-Transistoren und mindestens zwei Low-Side-Transistoren, die jeweils parallel geschaltet sind. Die Anzahl der High-Side-Transistoren ist gleich der Anzahl der Low-Side-Transistoren und jeweils geradzahlig. Vorzugsweise ist die Anzahl der High-Side-Transistoren 2 oder 4.

Die Transistoren sind auf einem gemeinsamen Substrat mit einer Metallisierung angeordnet. Die High-Side-Transistoren und die Low-Side-Transistoren sind jeweils spiegelsymmetrisch zueiander angeordnet oder um 180° gedreht zueinander angeordnet. Weiter sind Kontaktlaschen für einen positiven Spannungsanschluss, einen negativen Spannungsanschluss und einen Phasenanschluss jeweils spiegelsymmetrisch ausgebildet. Zwischen den High-Side-Transistoren und zwischen den Low-Side-Transistoren ist mindestens ein zusätzliches Substrat auf die Metallisierung des Substrats aufgebracht. Weiter ist mindestens ein gemeinsamer Gate-Anschluss für die High-Side-Transistoren und ein gemeinsamer Gate-Anschluss für die Low-Side-Transistoren auf dem mindestens einen zusätzlichen Substrat angeordnet. Bei der spiegelsymmetrischen Anordnung ist die Spiegelachse der High-Side-Transistoren gleich der Spiegelachse der Low-Side-Transistoren und der Kontaktlaschen. Hierdurch ist sowohl der Leistungspfad als auch der Signalpfad symmetriert. Durch das Zusatzsubstrat muss die Metallisierung des Substrats weniger stark strukturiert werden (z.B. durch Ätzen), sodass der elektrische Widerstand kleiner ist und das thermische Verhalten verbessert ist, da die Wärme besser verteilt werden kann. Dies wird ermöglicht, da der Signalpfad auf das oder die zusätzlichen Substrate ausgelagert wird. Die Transistoren sind vorzugsweise MOSFETs und weiter vorzugsweise SiC- oder GaN-Transistoren. Vorzugsweise werden die High-Side-Transistoren und die Low-Side-Transistoren vor dem Einbau selektiert, d.h. es werden jeweils Transistoren mit ähnlichen Eigenschaften ausgewählt (z.B. ähnlicher Gate-Treshold-Spannung). Ist im Signalpfad nur ein Gate-Anschluss, so kann dieser Gate-Anschluss mittig auf dem Transistor angeordnet werden, sodass die gleichen Transistoren verwendet werden können, egal ob diese links oder rechts von dem zusätzlichen Substrat angeordnet sind.

In einer Ausführungsform sind zwei zusätzliche Substrate vorgesehen, wobei ein zusätzliches Substrat den Gate-Anschluss für die High-Side-Transistoren und das weitere zusätzliche Substrat den Gate-Anschluss für die Low-Side-Transistoren aufweist. Die Verwendung von zwei zusätzlichen Substraten hat Vorteile bei der Gewährleistung der galvanischen Trennung der Metallisierung des Substrats zwischen den High-Side- und Low-Side-Transistoren.

In einer weiteren Ausführungsform ist auf dem zusätzlichen Substrat oder den beiden zusätzlichen Substraten jeweils ein gemeinsamer Kelvin-Source-Kontakt für die High-Side- und die Low-Side-Transistoren angeordnet. Durch den zusätzlichen Kelvin-Source-Kontakt sind nun zwei Anschlüsse im Signalpfad. Dies führt bei der spiegelsymmetrischen Anordnung dazu, dass die Transistoren auf der linken Seite des zusätzlichen Substrats anders aufgebaut sind als auf der rechten Seite des zusätzlichen Substrats. Dafür ist der Signalpfad weiter voll symmetrisch. Verwendet man hingegen gleiche Transistoren, die um 180° gedreht sind, so kann dies zu leichten Unsymmetrien führen.

In einer weiteren Ausführungsform ist auf den Transistoren ein Gate-Anschluss angeordnet, um den symmetrisch zwei Kelvin-Source-Anschlüsse angeordnet sind. Alternativ ist auf den Transistoren ein Kelvin-Source-Kontakt angeordnet, um den symmetrisch zwei Gate-Anschlüsse angeordnet sind. Die zwei Kelvin-Source-Anschlüsse oder die zwei Gate-Anschlüsse sind dabei vorzugsweise intern miteinander verbunden. Hierdurch kann auf beiden Seiten des mindestens einen zusätzlichen Substrats der gleiche Typ-Transistor verwendet werden, wobei der Signalpfad vollständig symmetriert ist.

In einer weiteren Ausführungsform sind auf dem oder den zusätzlichen Substraten Anschlüsse für eine Temperaturmessung mindestens eines High-Side- und eines Low-Side-Transistors angeordnet. Diese müssen nicht symmetrisch sein, da diese keinen Einfluss auf den Signalpfad haben.

In einer weiteren Ausführungsform sind das zusätzliche Substrat oder die zusätzlichen Substrate als DBC- (Direct Bonded Copper) oder als AMB- (Active Metal Brazing) Substrat ausgebildet.

In einer weiteren Ausführungsform sind das zusätzliche Substrat oder die zusätzlichen Substrate mit der Metallisierung des Substrats durch eine Klebe-, Löt- oder Sinterverbindung miteinander verbunden.

In einer weiteren Ausführungsform sind für den positiven Spannungsanschluss zwei separate Kontaktlaschen vorgesehen. Alternativ kann auch vorgesehen sein, dass für den negativen Spannungsanschluss zwei separate Kontaktlaschen vorgesehen sind.

Weiter sind die Anschlüsse des zusätzlichen Substrats oder der zusätzlichen Substrate als Steuerpins ausgebildet, die senkrecht zur Oberseite des oder der zusätzlichen Substrate ausgerichtet sind. Beispielsweise sind diese als Pressfit-Kontakte ausgebildet.

In einer weiteren Ausführungsform sind die Anschlüsse des oder der zusätzlichen Substrate mittels Bonddrähten mit den High-Side- und Low-Side-Transistoren verbunden.

In einer weiteren Ausführungsform sind die High-Side- und Low-Side-Transistoren als bare dies ausgebildet.

Weiter vorzugsweise sind mehrere Halbbrückenschaltungen auf einem gemeinsamen Kühlkörper angeordnet.

Weiter vorzugsweise sind die Halbbrückenschaltungen mit einer Moldmasse vergossen.

Die Erfindung wird nachfolgend anhand eines bevorzugten Ausführungsbeispiels näher erläutert. Die Figuren zeigen:
- Fig. 1: eine perspektivische Darstellung einer Halbbrückenschaltung in einem Gehäuse,
- Fig. 2: eine Draufsicht auf die Halbbrückenschaltung ohne Gehäuse,
- Fig. 3: eine perspektivische Darstellung auf die Halbbrückenschaltung ohne Gehäuse,
- Fig. 4: eine perspektivische Darstellung auf die Halbbrückenschaltung ohne Kontaktlaschen,
- Fig. 5: eine perspektivische Darstellung auf ein zusätzliches Substrat ohne Steuerpins,
- Fig. 6: eine schematische Darstellung eines Transistorpaares mit jeweils einem Gate-Anschluss und einem Kelvin-Source-Anschluss und spiegelsymmetrischer Anordnung,
- Fig. 7: eine schematische Darstellung eines Transistorpaares mit jeweils einem Gate-Anschluss und einem Kelvin-Source-Anschluss, wobei die Transistoren um 180° rotiert zueinander angeordnet sind und
- Fig. 8: eine schematische Darstellung eines Transistorpaares mit einem Gate-Anschluss und zwei Kelvin-Source-Anschlüssen.

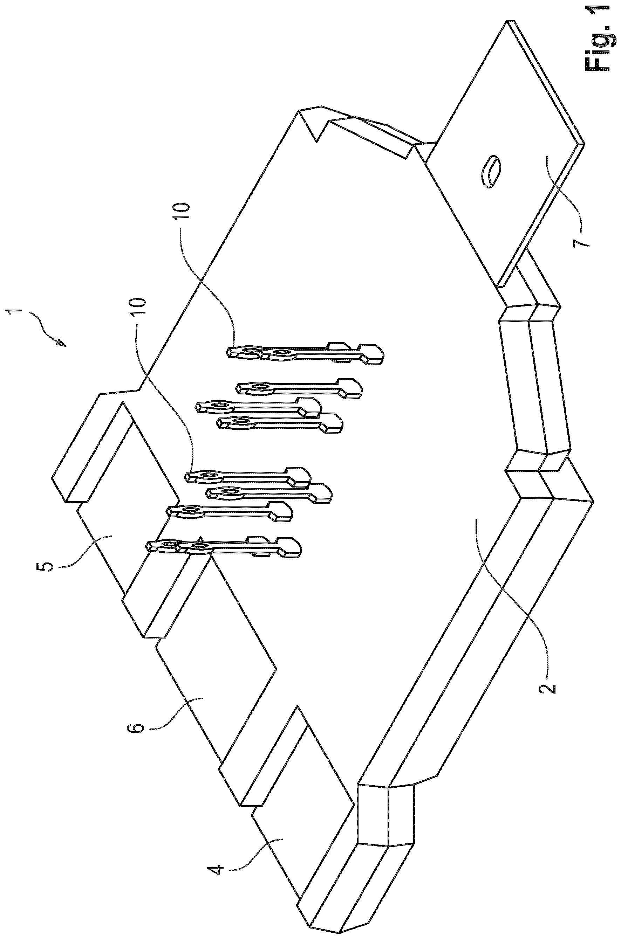

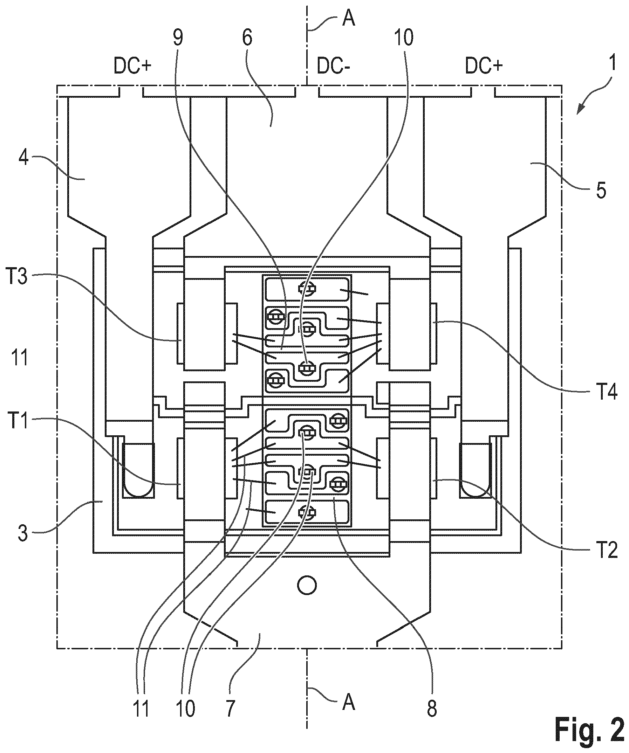

In der Fig. 1 ist eine Halbbrückenschaltung 1 mit einem Gehäuse 2 und in Fig. 2 ohne das Gehäuse 2 dargestellt. Die Halbbrückenschaltung 1 weist einen ersten High-Side-Transistor T1 und einen zweiten High-Side-Transistor T2 auf, die parallel geschaltet sind. Des Weiteren weist die Halbbrückenschaltung 1 einen ersten Low-Side-Transistor T3 und einen zweiten Low-Side-Transistor T4 auf, die ebenfalls parallel geschaltet sind. Die Transistoren T1-T4 sind auf einem gemeinsamen Substrat 3 mit einer strukturierten Metallisierung angeordnet. Weiter sind zwei Kontaktlaschen 4, 5 für den positiven Spannungsanschluss DC+, eine Kontaktlasche 6 für den negativen Spannungsanschluss DC- und eine Kontaktlasche 7 für einen Phasenanschluss vorgesehen. Die Kontaktlasche 4 ist dabei über die Metallisierung mit dem Drain-Anschluss des ersten High-Side-Transistors T1 verbunden. Entsprechend ist die Kontaktlasche 5 über die Metallisierung mit dem zweiten High-Side-Transistor T2 verbunden, wobei die beiden Drain-Anschlüsse der Transistoren T1, T2 über die Metallisierung verbunden sind. Über die Kontaktlasche 6 ist der negative Spannungsanschluss DC- mit den Source-Anschlüssen der beiden Low-Side-Transistoren T3, T4 verbunden. Die Kontaktlasche 7 kontaktiert die Source-Anschlüsse der beiden High-Side-Transistoren T1, T2 und die Drain-Anschlüsse der beiden Low-Side-Transistoren T3, T4. Die Kontaktlaschen 4-7 sind vorzugsweise als lead-frames ausgebildet. Weiter ist auf der Metallisierung des Substrats 3 ein erstes zusätzliches Substrat 8 und ein zweites zusätzliches Substrat 9 angeordnet. Dabei ist das erste zusätzliche Substrat 8 den High-Side-Transistoren T1, T2 und das zweite zusätzliche Substrat 9 den Low-Side-Transistoren T3, T4 zugeordnet. Auf der Oberseite der beiden zusätzlichen Substrate 8, 9 ist jeweils eine strukturierte Metallisierung aufgebracht. Auf den beiden zusätzlichen Substraten 8, 9 sind jeweils fünf Steuerpins 10 angeordnet, die senkrecht zur Oberfläche der zusätzlichen Substrate 8, 9 stehen.

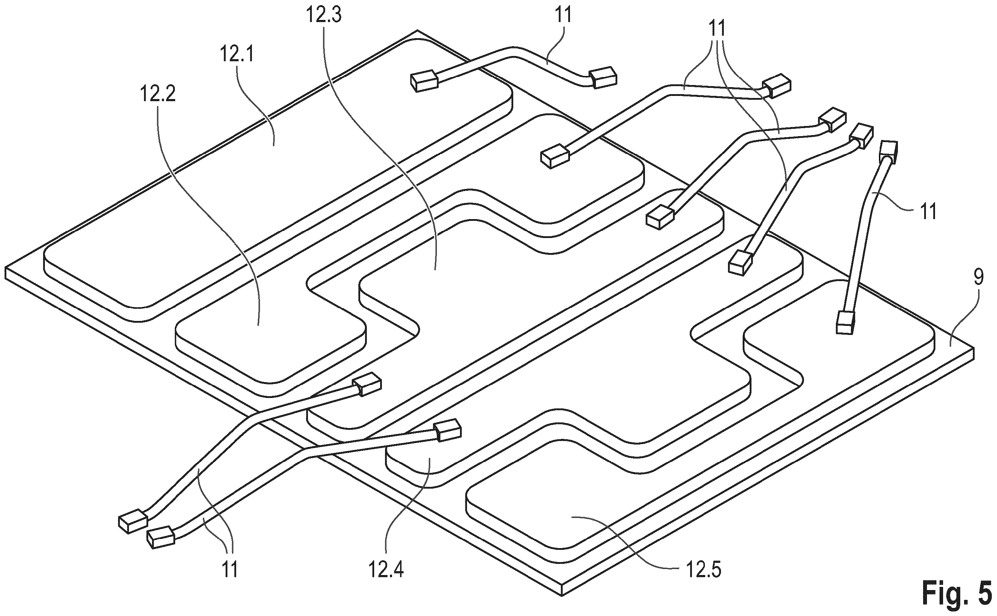

Die Funktionen der Steuerpins 10 soll nun anhand der Fig. 5 näher erläutert werden, wobei das zusätzliche Substrat 9 für die Low-Side-Transistoren T3, T4 ohne Steuerpins 10, aber mit Bonddrähten 11 dargestellt ist. Dabei sind auf dem zusätzlichen Substrat 9 fünf voneinander getrennte Metallisierungen 12.1-12.5 aufgebracht. Dabei ist auf der Metallisierung 12.3 ein Steuerpin 10 symmetrisch angeordnet (siehe auch Fig. 2), der als gemeinsamer Gate-Anschluss für die beiden Low-Side-Transistoren T3, T4 dient. Auf der Metallisierung 12.4 ist symmetrisch ein Steuerpin 10 angeordnet, der als gemeinsamer Kelvin-Source-Anschluss der beiden Low-Side-Transistoren T3, T4 dient. Daher gehen zu beiden Seiten Bonddrähte 11 ab, die ebenfalls symmetrisch angeordnet sind. Dabei können die beiden Steuerpins 10 auch vertauscht werden. Die Bonddrähte 11 der Metallisierungen 12.2 und 12.5 sind mit der Kathode bzw. Anode eines pn-Übergangs des zweiten Low-Side-Transistors T4 verbunden und dienen einer Temperaturmessung. Die Metallisierung 12.1 ist über den Bonddraht 11 mit den beiden Drainanschlüssen der beiden Low-Side-Transistoren T3, T4 über die Metallisierung des Substrats 3 verbunden. Entsprechendes gilt für das erste zusätzliche Substrat 8.

Hierdurch wird erreicht, dass sowohl der Leistungspfad als auch der Signalpfad der Halbbrückenschaltung 1 vollständig symmetriert ist, was anhand von Fig. 2 näher erläutert werden soll, wo eine Spiegelachse A eingezeichnet ist. Dabei sind alle Kontaktlaschen 4-7 spiegelsymmetrisch angeordnet. Auch die beiden High-Side-Transistoren T1, T2 sind spiegelsymmetrisch zur Spiegelachse A angeordnet, ebenso wie die beiden Low-Side-Transistoren T3, T4. Auch die beiden gemeinsamen Gate-Anschlüsse und die beiden gemeinsamen Kelvin-Source-Anschlüsse sind symmetrisch zu den zugeordneten Transistoren T1, T2 bzw. T3, T4 angeordnet und liegen auf der Spiegelachse A. Die Steuerpins 10 für die Messungen der Temperatur sowie die Drainspannung der Low-Side-Transistoren T3, T4 bzw. die Sourcespannung für die High-Side-Transistoren T1, T2 haben hingegen keinen Einfluss auf den Steuerpfad.

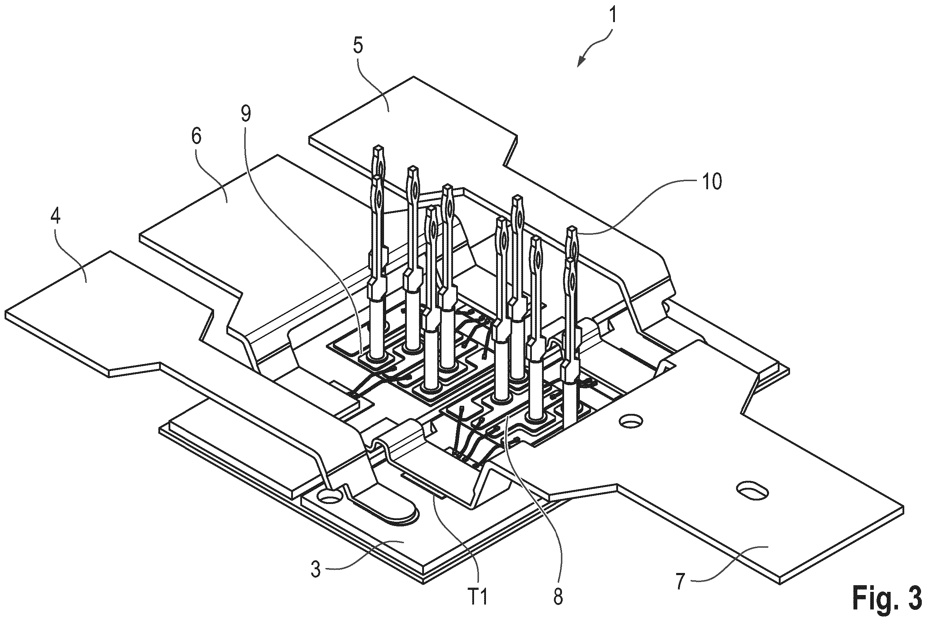

In der Fig. 3 ist die Halbbrückenschaltung 1 perspektivisch dargestellt, um die einzelnen Abwinklungen der Kontaktlaschen 4-7 besser zu zeigen.

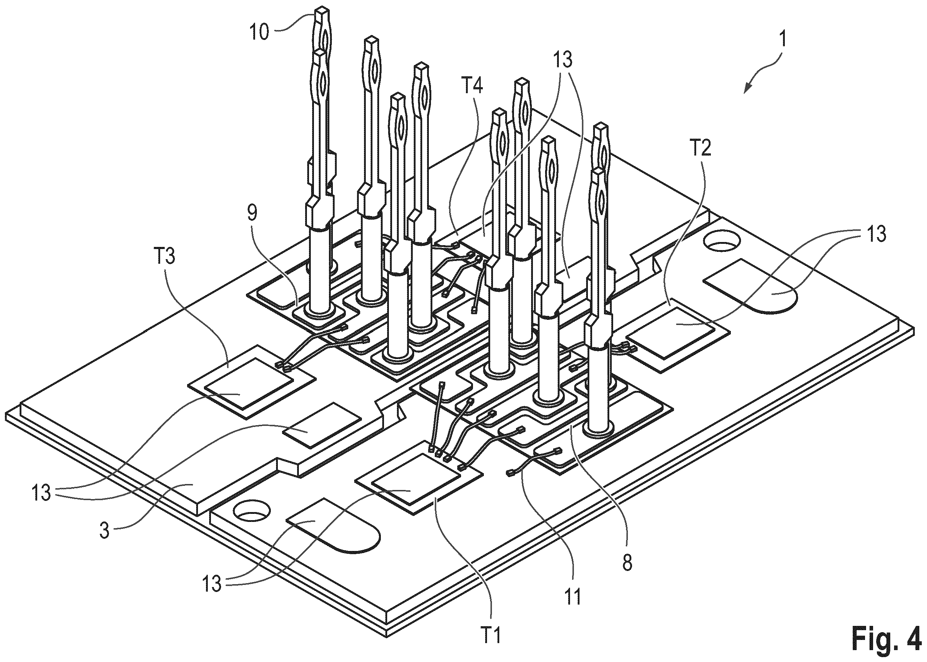

In Fig. 4 ist die Halbbrückenschaltung 1 ohne die Kontaktlaschen 4-7 dargestellt, wobei die Kontaktflächen 13 auf dem Substrat 3 bzw. den Transistoren T1-T4 für die Kontaktlaschen 4-7 dargestellt sind.

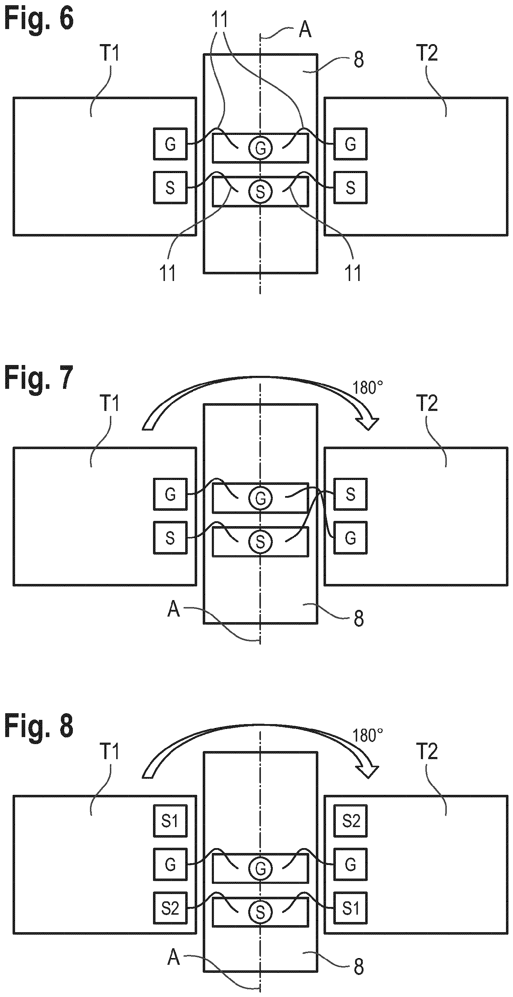

In der Fig. 6 ist schematisch eine spiegelsymmetrische Anordnung dargestellt, die an den High-Side-Transistoren T1, T2 erläutert werden soll. Zwischen den beiden High-Side-Transistoren T1, T2 ist das zusätzliche Substrat 8 angeordnet. Durch das zusätzliche Substrat 8 verläuft die Spiegelachse A. Die beiden High-Side-Transistoren T1, T2 weisen jeweils einen Gate-Anschluss G und einen Kelvin-Source-Anschluss S auf. Auf dem zusätzlichen Substrat 8 ist jeweils ein gemeinsamer Gate-Anschluss G und ein gemeinsamer Kelvin-Source-Anschluss S dargestellt, wobei die elektrische Verbindung über Bonddrähte 11 erfolgt. Dabei ist der Aufbau der beiden Transistoren T1, T2 unterschiedlich, aber dafür der Signalpfad vollständig symmetrisch.

In der Fig. 7 ist nun dargestellt, wenn man für die Transistoren T1, T2 baugleiche Transistoren verwendet und diese um 180° rotiert, wobei die Rotationsachse mittig durch das zusätzliche Substrat 8 geht (wie ein Normalenvektor). In diesem Fall ist der Signalpfad nicht vollständig symmetrisch.

Die Lösung dieses Problems ist in Fig. 8 dargestellt, wobei die beiden Transistoren T1, T2 baugleich sind. Hierdurch ist die Anordnung spiegelsymmetrisch und vollständig symmetrisch hinsichtlich des Signalpfades. Analog kann vorgesehen sein, dass ein mittiger Kelvin-Source-Anschluss vorgesehen ist, um den symmetrisch zwei Gate-Anschlüsse auf den Transistoren T1, T2 angeordnet sind.

### Bezugszeichenliste

- 1: Halbbrückenschaltung
- 2: Gehäuse
- 3: Substrat
- 4-7: Kontaktlaschen
- 8: Substrat
- 9: Substrat
- 10: Steuerpin
- 11: Bonddraht
- 12.1-12.5: Metallisierungen
- 13: Kontaktfläche
- A: Spiegelachse
- T1: erster High-Side-Transistor
- T2: zweiter High-Side-Transistor
- T3: erster Low-Side-Transistor
- T4: zweiter Low-Side-Transistor

## Patentansprüche

1. Halbbrückenschaltung (1), umfassend mindestens zwei High-Side-Transistoren (T1, T2) und mindestens zwei Low-Side-Transistoren (T3, T4), die jeweils parallel geschaltet sind, wobei die Transistoren (T1-T4) auf einem gemeinsamen Substrat (3) mit einer Metallisierung angeordnet sind, wobei die mindestens zwei High-Side-Transistoren (T1, T2) und die mindestens zwei Low-Side-Transistoren (T3, T4) jeweils spiegelsymmetrisch zueinander angeordnet sind oder um 180° gedreht zueinander angeordnet sind, wobei Kontaktlaschen (4-7) für einen positiven Spannungsanschluss (DC+), einen negativen Spannungsanschluss (DC-) und einen Phasenanschluss jeweils spiegelsymmetrisch ausgebildet sind, wobei zwischen den High-Side-Transistoren (T1, T2) und zwischen den Low-Side-Transistoren (T3, T4) mindestens ein zusätzliches Substrat (8, 9) auf die Metallisierung des Substrats (3) aufgebracht ist, wobei ein gemeinsamer Gate-Anschluss für die High-Side-Transistoren (T1, T2) und ein gemeinsamer Gate-Anschluss für die Low-Side-Transistoren (T3, T4) auf dem mindestens einen zusätzlichen Substrat (8, 9) ist.

2. Halbbrückenschaltung nach Anspruch 1, **dadurch gekennzeichnet, dass** zwei zusätzliche Substrate (8, 9) vorgesehen sind, wobei ein zusätzliches Substrat (8) den Gate-Anschluss für die High-Side-Transistoren (T1, T2) und das weitere zusätzliche Substrat (9) den Gate-Anschluss für die Low-Side-Transistoren (T3, T4) aufweist.

3. Halbbrückenschaltung nach einem der vorangegangenen Ansprüche, **dadurch gekennzeichnet, dass** auf dem oder den zusätzlichen Substraten (8, 9) ein gemeinsamer Kelvin-Source-Kontakt für die High-Side-Transistoren (T1, T2) und ein gemeinsamer Kelvin-Source-Kontakt für die Low-Side-Transistoren (T3, T4) angeordnet ist.

4. Halbbrückenschaltung nach einem der vorangegangenen Ansprüche, **dadurch gekennzeichnet, dass** auf den Transistoren (T1-T4) ein Gate-Anschluss (G) angeordnet ist, um den symmetrisch zwei Kelvin-Source-Anschlüsse (S1, S2) angeordnet sind, oder dass auf den Transistoren (T1-T4) ein Kelvin-Source-Anschluss angeordnet ist, um den symmetrisch zwei Gate-Anschlüsse angeordnet sind.

5. Halbbrückenschaltung nach einem der vorangegangenen Ansprüche, **dadurch gekennzeichnet, dass** auf dem oder den zusätzlichen Substraten (8, 9) Anschlüsse für eine Temperaturmessung mindestens eines High-Side-Transistors (T1) und eines Low-Side-Transistors (T4) angeordnet sind.

6. Halbbrückenschaltung nach einem der vorangegangenen Ansprüche, **dadurch gekennzeichnet, dass** das zusätzliche Substrat oder die zusätzlichen Substrate (8, 9) als DBC- oder als AMB-Substrat ausgebildet sind.

7. Halbbrückenschaltung nach einem der vorangegangenen Ansprüche, **dadurch gekennzeichnet, dass** das zusätzliche Substrat oder die zusätzlichen Substrate (8, 9) mit der Metallisierung des Substrats (3) durch eine Klebe-, Löt- oder Sinterverbindung verbunden sind.

8. Halbbrückenschaltung nach einem der vorangegangenen Ansprüche, **dadurch gekennzeichnet, dass** für den positiven Spannungsanschluss (DC+) zwei separate Kontaktlaschen (4, 5) vorgesehen sind.

9. Halbbrückenschaltung nach einem der vorangegangenen Ansprüche, **dadurch gekennzeichnet, dass** die Anschlüsse des zusätzlichen Substrats oder der zusätzlichen Substrate (8, 9) als Steuerpins (10) ausgebildet sind, die senkrecht zur Oberseite des oder der weiteren Substrate (8, 9) ausgerichtet sind.

10. Halbbrückenschaltung nach einem der vorangegangenen Ansprüche, **dadurch gekennzeichnet, dass** die Anschlüsse des zusätzlichen Substrats oder der zusätzlichen Substrate (8, 9) mittels Bonddrähten (11) mit den High-Side-Transistoren (T1, T2) und den Low-Side-Transistoren (T3, T4) verbrunden sind.
